Europäisches Patentamt

(19)       European Patent Office

           Office européen des brevets                                (11)        **EP 0 851 579 A2**

(12)                              **EUROPEAN PATENT APPLICATION**

(43) Date of publication:                                   (51) Int. Cl.⁶: **H03H 17/02**
     **01.07.1998  Bulletin 1998/27**

(21) Application number: **97121969.6**

(22) Date of filing: **13.12.1997**

(84) Designated Contracting States:
     **AT BE CH DE DK ES FI FR GB GR IE IT LI LU MC
     NL PT SE**
     Designated Extension States:
     **AL LT LV MK RO SI**

(30) Priority: **16.12.1996 US 32978 P**

(71) Applicant:
     **Texas Instruments Incorporated
     Dallas, Texas 75265 (US)**

(72) Inventor: **Myers, William K.
     McKinney, TX 75070 (US)**

(74) Representative: **Holt, Michael
     Texas Instruments Limited,
     Kempton Point,
     68 Staines Road West
     Sunbury-on-Thames, Middlesex TW16 7AX (GB)**

(54)    **A digital filter**

(57)    A system for providing filtered baseband signals for controlling a modulator (26) includes a lookup table (2). The lookup table (2) contains entries corresponding to each of a variety of possible input data segments, each such data entry comprising a sequence of sampled data representing the convolution of the corresponding input sequence with the impulse response of a desired filter. As each new input data sequence is introduced to a register (6), a logic circuit (4) accesses the corresponding sampled data sequence and couples the sequence to the input of a digital to analog converter (8). The operation continues with subsequent input data segments so as to provide a continuous stream of data to the converter (8). The output of the converter (8) is operatively connected to a modulator (26).

FIG. 2

**Description**

FIELD OF THE INVENTION

This invention relates to a system for filtering digital data streams and, in the preferred embodiment, a system for filtering digital baseband signals for subsequent use in modulating a radio frequency signal.

BACKGROUND OF THE INVENTION

Digitally modulated signals are frequently filtered to limit the amount of the power spectrum occupied by the signal and to minimize the band energy. This filtering can be accomplished by filtering the digital signal prior to modulation or, alternatively, by bandpass filtering the modulated radio frequency signal. The ideal filter in many applications is a raised cosine filter with an impulse response which is not finite. It is difficult to implement the raised cosine filter as well as certain other filters using standard LC filter configurations.

For high speed data rates, it has been known in the prior art to perform modulation filtering at radio frequency using custom acoustic surface wave (SAW) filters. A disadvantage of using this technique is that SAW filters are quite expensive, and any given SAW filter is fixed for a particular data rate and filter response.

For lower speed applications it has been known to use digital signal processors (DSPs) to implement a finite impulse response (FIR) estimate of the filter in software. A disadvantage of using DSPs in this way is that the data rates must be low to allow the mathematical operations to be carried out in real time as a discrete instruction set. It should be understood, however, that the teachings disclosed herein may be practiced using one or more DSP(s) without suffering the slow speed disadvantage noted above.

SUMMARY OF THE INVENTION

A system for filtering high speed digital data for modulation using standard digital products is provided. In a preferred embodiment, the signal to be filtered comprises a sequence of binary bits, each occupying a finite and unvarying period of time. Thus this signal will always be at one of two levels, the first level corresponding to a binary one and the second level corresponding to a binary zero. In practice the filter operation may be approximated by dividing the data into finite time segments or blocks of these bits of data, e.g. a sequence of four, eight or sixteen bits. Each such segment is filtered individually to produce a filtered output signal corresponding to a certain time interval. After the individual segments have been so processed, the filtered output signals for the various time intervals are then concatenated to form a continuous filtered signal.

A method for accomplishing the filtering of the individual segments is also provided. For a finite length signal segment of the type described above, only a finite number of different input signals can occur. If the segment is comprised of four bits, for example, in one possible combination all four bits would be zero and the signal would remain at the level corresponding to a zero for the entire four bit duration. If only the first bit were a one, then the signal would be at the level corresponding to a one for the first interval, and at the level corresponding to a zero for the remainder of the segment. In the four bit case, only sixteen different such signal sets can exist. In the case of eight bits, thirty-two different signals can exist.

For each such possible input signal, the precise nature of the filtered output signal can be computed analytically, and the result stored in a table which may be resident in a memory such as a read-only-memory ("ROM"). Computation of the filtered output signal for a given combination of bits in the input signal is accomplished by convolving that sequence of input bits with the input response of the filter. Samples of the filtered signal, sufficiently closely spaced in time to allow subsequent reconstruction of an analog signal by a digital to analog converter, are then stored at an identified location in the ROM table. This process is repeated for each of the possible combinations of input signals with the result that sampled data representing all possible filtered output signals is stored in the ROM. Once the table is assembled, filtering of any specific input signal segment is accomplished by simply referring to the corresponding filtered output signal in the table and reading out the sampled data signal.

While any given filtered output signal stored in the ROM is determined by convolving the entire segment of input signal with the filter input response, the output signal stored in the ROM corresponds to only the time period occupied by the most recent bit of the segment. The convolution is performed, however, over the entire length of the segment because the state of the input signal for time periods prior to the most recent time period will influence the output of the filter during the most recent time period. Since the convolution is performed over a finite length of input signal, the result is an approximation of the output signal that would result from a continuous application of a filter with the same impulse response to continuous data. In practice the longer the segments of input data used, the closer is the approximation of the true filtered output. While the filtered data in the table may be derived by performing a convolution operation as described above, other methods may be effectively implemented.

The system for implementing the filtering function includes an N-bit register for accepting the input stream of bits. The number of bits in the register, N, corresponds to the number of bits in the segment length. A sequence of N consecutive binary bits or symbols is clocked into the register. This sequence includes the most recent bit or symbol in the binary data stream to be filtered along with the preceding N-1 bits or symbols of the stream. In the case of a four bit register, for example, the contents of the register at some point in time might be 0101 or 1001 where the last 1 in either sequence is the most recent bit or symbol for that sequence. The data contained in any single stage of the register may represent either a single binary bit, or it may be a symbol which has been derived from other digital data. In either case the data will occur in the register state as either a high or a low logic level. Henceforth in this description the term "bit" will be used but should be understood to encompass either bits or symbols of information.

The system also includes a look-up table which contains a plurality of sets of data samples, each set corresponding to one of the possible sequences which may be resident in the register. Each such set of data samples constitutes a set of digital numbers which represent a sampled data version of the filtered output signal corresponding to one of the possible sequences of ones and zeroes in the input signal segment. In a preferred embodiment, a raised cosine filter is employed. Henceforth in this description, the individual signals in the lookup table will be referred to as sampled data filtered signals. While the impulse response of the raised cosine filter is infinite in extent, since the impulse response is convolved with only a finite sequence of binary bits or symbols, the effect is as if the filter impulse response was truncated in time.

A logic circuit couples the contents of the register to the input of the look-up table. The logic circuit operates to convert the binary data in the register to a table address in the look-up table so as to select the corresponding sampled data filtered signal in the look-up table. The selected sample data filtered signal is clocked out of the look-up table and provided to the input of a digital-to-analog converter. The converter serves to convert the sampled data filtered signal to an analog base band waveform. In a preferred embodiment, the analog output of the A-D converter is filtered by a low pass filter prior to being used in a modulator.

BRIEF DESCRIPTION OF THE DRAWINGS

The present invention will now be further described by way of example, with reference to the accompanying drawings in which;

Figure 1(a) illustrates a frequency domain spectral response of a raised cosine filter.
Figure 1(b) illustrates a time domain impulse response of a raised cosine filter; and
Figure 2 is a block diagram of the filter of the present invention.

DESCRIPTION OF THE PREFERRED EMBODIMENT

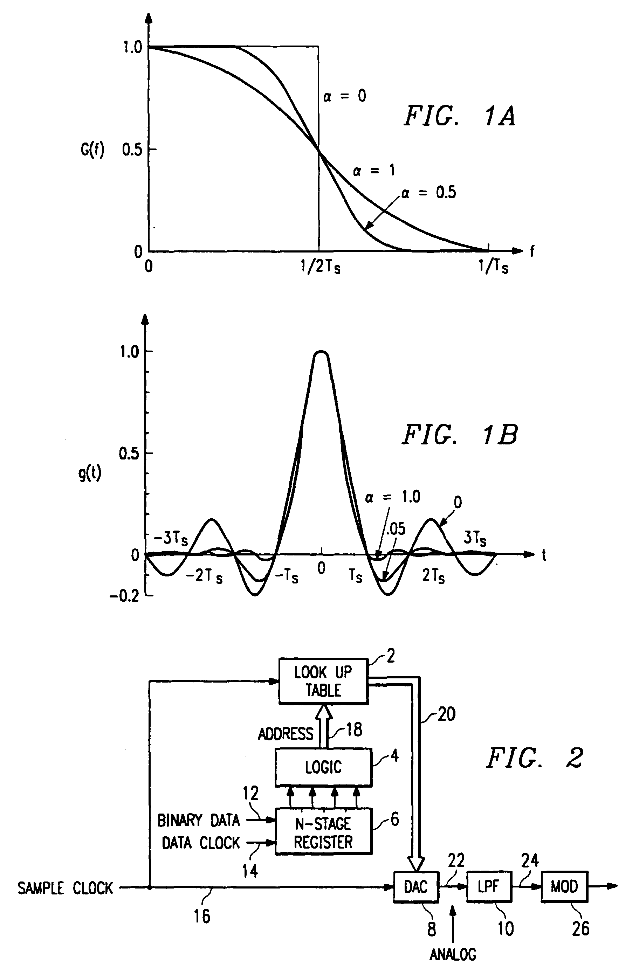

Figure 1(a) illustrates the frequency domain spectral response of a raised cosine filter, while Figure 1(b) illustrates the corresponding time domain impulse response. The impulse response is of the form:

$$\frac{\sin (\pi t/T_s)}{(\pi t/T_s)} \frac{\cos (\pi \alpha t/T_s)}{1-(2 \alpha t/T_s)^2}$$

Responses are shown for several values of alpha, the excess bandwidth factor. In the limiting case where alpha = 0, the time domain impulse response is that of a minimum bandwidth brick wall filter and is in the form of a sin x/x function. When alpha is greater than zero, the side lobes of the impulse response decay more rapidly than for the sin x/x response.

In a preferred embodiment, the filter employed has the impulse response of the raised cosine function, but with truncation of the Nth and higher order sidelobes. This approximation provides a frequency spectrum that varies from the ideal spectrum. The allowable deviation determines the value of N, the register length.

Figure 2 illustrates a system that is comprised of a look-up table 2, logic circuit 4, N-stage register 6, digital-to-analog converter (DAC)8, low pass filter 10 and modulator 26. Data clock 14 clocks binary data 12 into register 6. Register 6 is shown in Figure 2 as having four stages, but other register lengths may be utilized as a function of the desired accuracy of the system. In the illustration of Figure 2, the leftmost stage of register 6 will contain the most recent binary bit while the other three stages will contain the three immediately preceding bits. Depending on the actual value of the data present at any given point in time, the four bit register can contain any one of sixteen combinations of ones and zeroes.

Given the four bit register 6 of Figure 2, lookup table 2 will contain sixteen distinct sampled data filtered signals, each such signal corresponding to one of the sixteen possible combinations of ones and zeroes that may occur in register 6. Each set consists of sampled data values of a filtered version of the corresponding combination of ones and zeroes in register 6. More specifically, each such set contains time spaced samples of the signal which can be thought of as the convolution of the truncated raised cosine filter with the corresponding set of ones and zeroes in register 6. Lookup table 2, in the illustrated preferred embodiment is located in a read-only-memory (ROM), but could alternatively be located in various other types of memory such as EPROM, EEPROM, RAM, VRAM or other devices capable of storing the sets of data samples and producing them upon demand.

Logic circuit 4 operates in response to the contents of register 6 and sends an address over bus 18 to address the corresponding sampled data filtered signal in lookup table 2. While, in the illustrated preferred embodiment, bus 18 is a parallel bus, it may sometimes be desirable to send the address as a serial data stream.

As noted above, the addressed set of data samples represents the filtered version of the data present in register 6 and is present, on bus 20, at the input of DAC 8. Again, while bus 20 is a parallel bus, it may be desirable in certain cases to use a serial bus in the alternative. DAC 8 serves to convert the sampled data signal at its input to a corresponding analog signal at its output 22. The signal present on line 22 then goes to low pass filter 10 which serves to remove spurious frequencies which may have been introduced by the operation of DAC 8. Finally, the filtered analog signal is coupled by line 24 to modulator 26 wherein it is used to modulate the RF signal output of the modulator.

While the apparatus of Figure 2 is shown with a single input to modulator 26, it is well known in the art to accomplish the multiplexing function with a quadrature modulator for which I & Q baseband analog input signals must be provided. In such case two circuits such as that illustrated in Figure 2 would be provided so as to develop the two required baseband analog input signals.

In the case of a four bit register, a standard binary to decimal converter such as the SN74154 integrated circuit available from Texas Instruments Incorporated may be used as logic circuit 4. The AD9760 integrated circuit available from Analog Devices may be used as digital to analog converter 8. Low pass filter 10 may be a standard LC low pass filter comprised of inductors and capacitors as is well known in the art. Modulator 26 may be an RG2422 integrated circuit available from RF Micro Devices or an HPMX2005 integrated circuit available from Hewlett Packard.

In operation, the system of Figure 2 functions as follows. The system may be used in either the continuous or burst mode. In the former case, input data is provided to the filter system continuously. In the burst mode, input data is provided only intermittently. Initially, or at the beginning of each packet of input data in the burst mode, a series of N bits will be clocked into register 6 on line 12 under control of data clock 14. In the illustration of Figure 2, the leftmost bit in register 6 will then be the most recent data bit, while the other three stages will contain the immediately preceding three data bits. The four bits resident in register 6 are then used by logic circuit 4 to address the corresponding sampled data filtered signal in lookup table 2. This sampled data signal represents the filtered signal for the most recent bit which is located in the leftmost stage of register 6, and is equal in time duration to the time duration of that most recent bit. The sampled data values for this last bit, however, will be influenced by the values in the other three stages of register 6 since the convolution will have been performed over these three bits as well as the most recent bit. This sampled data signal is clocked out of lookup table 2 and into DAC 8 under control of the sample clock signal 16. The analog baseband output signal of DAC 22 is then low pass filtered before being coupled to modulator 26.

Data clock 14 next clocks a new "most recent bit" into register 6, and the process continues on as hereinabove described. The result is a continuous stream of sampled data flowing to the DAC 8, representing the filtered output signal. While a raised cosine filter is used in the preferred embodiment, this is but one in a broader class of filters sometime referred to as partial response filters. In certain applications, it may be advantageous to use other partial response filters or alternatively, other filters not from this class.

Modification of the illustrated preferred embodiments to allow for the use of various filters is a simple matter. A user may, for example, wish to modify the value of alpha used in the raised cosine filter. This is accomplished by simply replacing the data in the lookup table with the sampled data filtered signals corresponding to the modified raised cosine filter. Alternatively, it may be desirable in some cases to replace the data in the lookup table with sampled data filtered signals corresponding to convolution with a filter other than the raised cosine filter.

Since it is obvious that many additional changes and modifications can be made in the above-described details without departing from the nature and spirit of the invention, it is understood that the invention should not to be limited to said details.

**Claims**

1. A filter for processing data symbols comprising:

   a register for receiving sequences of said data symbols;
   a lookup table containing sets of data, each set corresponding with one of said sequences of data symbols; and
   a logic circuit responsive to a data symbol sequence present in said register for selecting the corresponding set of data from said lookup table.

2. The filter of Claim 1, wherein each set of data located in said lookup table results from the convolution of the corresponding data symbol sequence with a truncated desired impulse response.

3. The filter of Claim 2, wherein said truncated desired impulse response is that of a raised cosine filter.

4. The filter of Claim 1, wherein the data located in said lookup table results from the convolution of a truncated desired impulse response with the corresponding sequence of data samples.

5. The filter of Claim 4, further comprising:

   a digital to analog converter responsive to said selected set of data from said lookup table to provide an analog waveform corresponding to said selected set of data.

6. The filter of Claim 5, further comprising a modulator operatively connected to and responsive to the output from said digital to analog converter.

7. A method of processing sequences of data symbols, comprising:

   providing a sequence of input data symbols;
   responsive to said sequence of input data symbols, accessing data from a corresponding one of a series of storage locations, each of said storage locations containing sampled data representing a convolution of a desired impulse response with a sequence of input data symbols;
   providing said data from a corresponding one of a series of storage locations to an analog to digital converter; and
   repeating the above steps iteratively.

8. The method of Claim 7, further comprising the step of providing an output of said digital to analog converter to a modulator.

FIG. 1A

FIG. 1B

FIG. 2